# EUROPEAN PATENT APPLICATION

(11) **EP 1 137 330 A1**
(43) Date of publication of application: **26.09.2001**
(21) Application number: 00920757.2
(22) Date of filing: 26.04.2000
(51) Int. Cl.: H05K 3/34

(54) **PATTERN DESIGN FOR ELECTRONIC COMPONENTS ON A 400 MICRON COPPER LAYER IN PRINTED CIRCUITS**

(30) Priority: 08.06.1999 ES 9901256
(71) Applicant: Lear Automotive (EEDS) Spain, S.L., 43800 Valls, Tarragona (ES)
(72) Inventor: BOIXADERA FERRER, Joan Maria, E-43800 Valls (ES)
(74) Representative: Primo de Rivera y Urquijo, Jose Antonio
(86) International application number: ES0000151
(87) International publication number: WO0076280

(57) **Abstract**

In order to ensure manufacturability of electronic circuits with conductor strips having a copper width of over 105 microns, a new series of patterns has been designed for each of the components. A copper surface has been added to said components to receive the adhesive drops thereby compensating for the height difference if the copper surface is bigger than 105 microns. If the width of the areas of the electronic component which are to be connected to the conductive coating of the printed circuit had a width a₁, the width according to the invention is now a₂, thereby making it possible to deposit the corresponding adhesive material in said strip having width a₂.

## Description

More specifically, the invention refers to a widening of the contact areas arranged on printed circuits and of their conducting zones to receive the conducting parts of the electronic components to be incorporated on said printed circuit.

Known printed circuits consist of a substrate of dielectric material, over which the corresponding conducting material tracks are printed, such as copper, aluminium or similar. Over said printed circuit, the corresponding electronic components are incorporated later, which the printed circuit requires to serve the entrusted purposes. For the latter and between the conducting material tracks, adhesive material is deposited, which permits the electronic components to be supported on the same, previously applied to the copper to be involved in the wave soldering process without them falling before being soldered, which occurs at the ends of the conducting parts, hence completing the process of incorporation of said components on the printed circuits.

Said process is conventional and used in the electronics industry and implies no special difficulty when working with printed circuits of up to 100 microns of copper on the conducting tracks. However, when the same operation is carried out on said printed circuits with conducting layers greater than 105 microns of copper, this same operation becomes almost impossible when executing it with the current production systems and methods.

To solve this problem and assure the manufacturability of electronic circuits, with conducting tracks of more than 105 microns of copper, a series of new figures has been designed for each one of the components to which a copper surface has been added intended to support the adhesive drops and hence, compensate the height difference represented by the copper when greater than 105 microns, that is, if the width of the electronic component zones destined to be interlocked with the conducting layer of the printed circuit were of a width a₁, the object of the present application has been designed with a width a₂, since in this way it is possible to deposit in this strip of width a₂, the corresponding adhesive material which previously, was deposited between the conducting areas, as may be seen in the figures, hence permitting that the electronic component remains temporarily stuck to the printed circuit board until reaching the wave soldering stage.

Other details and features of the present patent application will be shown in the description given below, referring to the figures attached to this specification where the mentioned details are represented. These details are given as an example, referring to a possible case of a practical embodiment, but not being limited to the details indicated herein. Therefore, this description should be considered as an illustration and without limits.

Below, there is a detailed list of the components mentioned in the present patent application, (10) printed circuit, (11) material substrate, (12) conducting material track, (13) electronic component, (13.1) electronic part, (13.2) conducting part, (14) adhesive, (15) solder.

Figure 1 is a simplified front elevation view of a printed circuit board (10) with a copper track (12) less than 105 microns thick, over which an electronic component (13) should be incorporated, applying an adhesive (14) between the copper tracks (12).

Figure 2 is a similar view to that of figure number 1, but at a later stage, that is, when incorporating the electronic component (13) to the copper track (12) and being interlocked to the same with a help of the adhesive (14) and later on is soldered by conventional methods and the soldering material deposited, such as tin or similar (15), said electronic component (13) being mechanically and electrically incorporated to the printed circuit board (10).

Figure 3 is a simplified front elevation view similar to figure 1, but when the copper track or conducting material has a height of h₂ instead of h₁.

Figure 4 is a front elevation view similar to figure 3, in which the conducting part (12) has been widened by (a₂-a₁) with the purpose that when it is desired to incorporate an electronic component (13) the adhesive (14) does not spill over the conducting part.

Figure 5 is a front elevation view similar to figure 3, but at a later moment when the electronic component (13) has been duly interlocked and soldered to the copper track (12) at a thickness greater than 105 microns and height h₂.

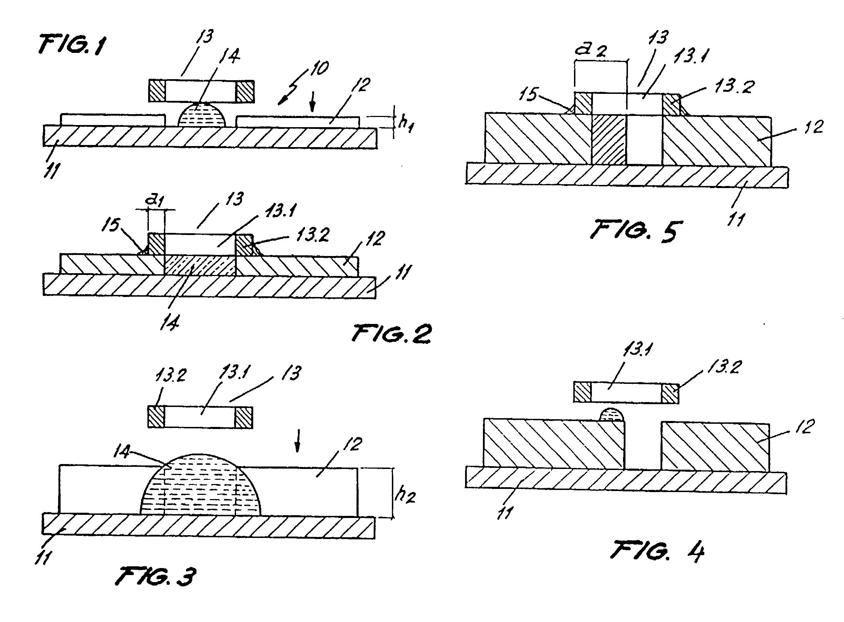

In one of the preferred embodiments of the object of the present application, which may be seen in figures number 3 and 4, when it is wished to incorporate an electronic component (13) to a printed circuit board (10) and when the latter is formed by a copper track or conducting material whose thickness h₂ is greater than 105 microns, the conventional methods indicated in figures 1 and 2 are not possible, that is, as a consequence of the difference of height of h₂ compared with h₁, a drop of glue (14) with a very large diameter should be incorporated, resulting in part of it being spilled over the layer (12) and being irregularly distributed over the zone (13.2) or conducting part of the electronic component which should be soldered later on, as may be seen in figure 3.

To prevent these drawbacks, some pads have been designed, that is, some zones to tint or receive a layer of adhesive with a greater surface, so that if in a conventional component, it were a₁, with the new design it is a₂; see figure 5, that is, greater than a₁ and as a result, the adhesive may be directly deposited on this area of the conducting layer or copper track (12), so that it is interlocked to the electronic component (13) to later on receive the solder (15) by conventional methods.

Concluding, the invention is reduced to an increase of width of the pads of the electronic components (13), hence able to permit the deposition of the adhesive drops on the conducting layer (12) and in this way, compensate the height difference of the copper track when this is greater than 105 microns.

Having sufficiently described the essence of the present patent application, according to the attached drawings, it is understood that any modifications may be introduced, as relevant, provided they do not alter the essence of the present patent, being summarised in the following claims.

## Claims

1. "DESIGN FOR ELECTRONIC COMPONENT PATTERNS OVER 400 MICRON LAYERS ON PRINTED CIRCUITS", consisting of a dielectric material substrate (11) over which, the conducting material tracks (12) are drawn and constructed, such as copper, aluminium or similar, depositing between said tracks (12) an adhesive material (14) with the purpose of interlocking to electronic components (13) as a preliminary step, so that once they are adhered to the conducting material track (12), they receive the corresponding soldering material (15) in a wave soldering process, **characterised in that** in the printed circuits (10) the layer of conducting material or copper track (12) will be h₂ greater than h₁ and the corresponding pads of width a₁ will have a greater width a₂.

2. "DESIGN FOR ELECTRONIC COMPONENT PATTERNS OVER 400 MICRON LAYERS ON PRINTED CIRCUITS" in accordance with claim 1, **characterised in that** the conducting parts (13.2) of electronic components (13) will have a width a₂ when the copper conducting layers (12) have a height h₂ greater than 105 microns.
